Europäisches Patentamt

European Patent Office

Office européen des brevets

(11) Publication number: **0 077 893**
**A2**

# (12) EUROPEAN PATENT APPLICATION

(21) Application number: **82107234.5**

(22) Date of filing: **10.08.82**

(51) Int. Cl.³: **H 01 L 21/285**
**H 01 L 23/34**

(30) Priority: **23.10.81 US 314278**

(43) Date of publication of application:
**04.05.83 Bulletin 83/18**

(84) Designated Contracting States:
**DE FR GB**

(71) Applicant: **International Business Machines
Corporation**

**Armonk, N.Y. 10504(US)**

(72) Inventor: **Heiblum, Mordehai
2375 Mark Road
Yorktown Heights New York 10598(US)**

(72) Inventor: **Nathan, Marshall Ira
106 Stephan Drive
Tarrytown New York 10591(US)**

(74) Representative: **Hobbs, Francis John
IBM United Kingdom Patent Operations Hursley Park
Winchester Hants, SO21 2JN(GB)**

(54) **Low-resistance ohmic contacts to n-type group III-V semiconductors.**

(57) A low resistance ohmic contact to a layer (6) of n-type GaAs is made by first vapour depositing layers (8, 10, 12) of Ni, Au and Ge on the GaAs, followed by a layer (14) of $SiO_2$. This structure is heated to a temperature of 450°C within ten seconds and the structure is maintained at that temperature for 30 seconds to form an alloy ohmic contact. The structure is then rapidly cooled by applying a heat sink (20) to the back surface (5) of the substrate (2) supporting the GaAs layer (6). The technique may be used to form ohmic contacts to other n-type Group III-V semiconductors. Ohmic contacts formed using this method exhibit a very fine, high density, uniform granular structure.

FIG. 1

LOW-RESISTANCE OHMIC CONTACTS TO N-TYPE GROUP III-V SEMICONDUCTORS

This invention relates to methods of forming contacts to n-type Group III-V semiconductors, such as gallium arsenide (GaAs).

The reliability and performance of GaAs devices, such as GaAs MESFET, are directly related to, among other things, the integrity of the low resistance ohmic contacts formed in conjunction with such semiconductor devices. Earlier contacting methods involve depositing solid solution of gold and germanium, or silver and germanium on a GaAs substrate and then applying sufficient heat to melt the metals by annealing through the eutectic temperature and thereby alloying the metal film with the substrate.

While these earlier methods produce ohmic contacts which are adequate for discrete device application, they suffer major disadvantages in large scale integration device processing, wherein low resistance contacts become essential. Major disadvantages of these earlier melting processes are the lack of uniform wetting of the metals to gallium arsenide, microsegregation and microcrystallization of the metals and GaAs, non-uniform germanium doping characteristics in the semiconductor regrown layer, out diffusion of gallium and arsenic from the GaAs to the top layer of the contact, and germanium surface roughness. Conventional contacts are usually not uniform and age fast because of the high local current density usually involved in such GaAs devices. These problems adversely affect the reliability, electrical resistance, and dimensional control of the contact metallization, and consequently affect also the reliability and performance of the GaAs devices.

Some prior disclosures of methods for making ohmic contacts to GaAs address the problem of the poor wetting action of a eutectic mixture of gold and germanium. For instance, U.S. Patent No. 3,386,867 issued to

**0077893**

J. L. Staples discloses the adding of nickel to the eutectic mixture of gold and germanium to yield a uniform contact surface.

Other prior methods for making ohmic contacts for GaAs also provide a AuGeNi metallurgy. As another example, in an article by N. Braslau et al, entitled, "Metal-Semiconductor Contacts for GaAs Bulk Effect Devices", Solid State Electronics, Vol. 10, pp. 381-383 (1967), an alloy of gold, germanium and nickel is shown to produce uniform linear electrical contacts to GaAs. Furthermore, an article by V. L. Ridecut entitled, "Ohmic Contact Technique for N-type GaAs, GaAsP, and GaAlAs", IBM Technical Disclosure Bulletin, Vol. 16, No. 9, February 1974, pp. 3070-3071, discloses that a process in which the nickel is replaced by platinum is better suited to the mass production of gold germanium alloy contacts for n-type GaAs, using an electron beam evaporator.

Another prior method for providing ohmic contacts to n-type Group III-V semiconductors is disclosed in U.S. Patent No. 4,188,710 (1980), issued to J. E. Davey et al. According to the patented method, a substrate is subjected successively to cleaning with trichloroethylene, acetone, and deionized water, etching with hydrofluoric acid, reetching and rinsing. The substrate is heated in an oil-free vacuum to desorb surface oxides. An epitaxial layer of Ge and a layer of Ni, are individually deposited on the substrate. The structure is annealed in the vacuum at temperatures high enough to diffuse the Ge and Ni with the substrate material. An ohmic contact having an ohmic resistivity in the range of $1 \times 10^{-6}$ $\Omega$ -cm² to $1 \times 10^{-5}$ $\Omega$ -cm² is achieved.

Still another prior method improving the ohmic properties of gold-germanium contacts to n-type GaAs is described by F. Vidimari in an article set forth in Electronis Letters 15, page 674 (1979). According to the article, contact resistivity of AuGe contacts on n-type GaAs is reduced by about one order of magnitude by replacing the conventional Ni top layer with an $SiO_2$ layer.

The invention provides a method of making an ohmic contact to an N-type Group III-V semiconductor layer supported on one surface of a substrate, the method comprising the successive steps of depositing a layer of contact material on the semiconductor layer, heating the structure to cause the contact material to form an alloy contact to the semiconductor layer and rapidly cooling the structure and being characterised by the rapid cooling being effected by removal of heat from the opposite surface of the substrate to that supporting the semiconductor layer by contacting said opposite surface with a heat sink.

How the invention can be carried out will now be described by way of example, with reference to the accompanying drawings, in which:-

FIG. 1 is a schematic diagram showing a structure formed prior to an alloying step;

FIG. 2 is a simplified schematic diagram illustrating the removal of heat from the back side of the substrate; and

FIG. 3 is a graph illustrating an alloying cycle employed in carrying out this invention.

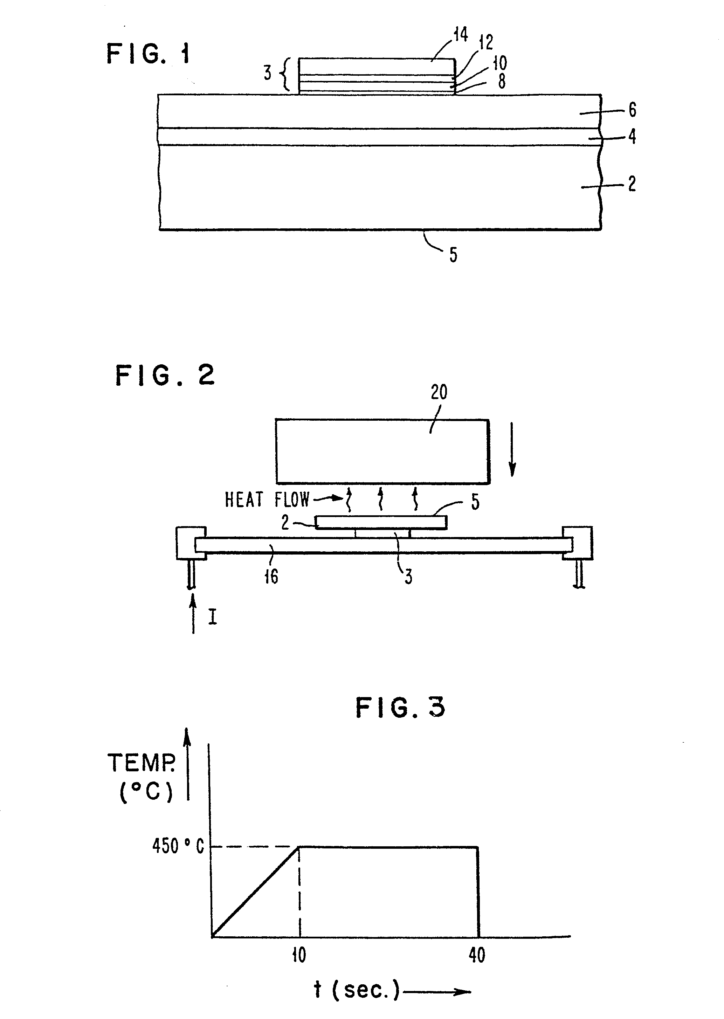

An undoped GaAs buffer layer 4 (FIG. 1) about 2000Å thick is grown on a semi-insulating GaAs wafer substrate 2 by molecular beam epitaxy (MBE) or by means of conventional chemical vapour deposition. An n-type GaAs layer 6 doped to about $10^{17}$ $cm^{-3}$ with Si, and from 0.1 to 1 micron thick is formed on top of the undoped GaAs buffer layer 4. Multi-layer contact metallurgy 3 is then formed on top of the doped GaAs layer 6. The multi-layer contact metallurgy 3 is formed by the sequential deposition in an electron beam evaporator of a layer 8 of Ni about 50 Å thick, a layer 10 of Au about 500 Å thick, a layer 12 of Ge about 250 Å thick and finally a layer 14 of $SiO_2$ approximately 2000 Å thick.

After forming the multi-layer contact metallurgy 3 the structure is placed facedown on an electric heating strip 16 (FIG. 2) and subjected to the heat cycle illustrated in FIG. 3. The temperature of the structure is raised quickly above the eutectic temperatures of both the multilayer metallurgy 3 and the n-type GaAs layer 6, i.e., to a temperature in the range of 400°C to 500°C, and preferably 450°C, in about 10 seconds. The temperature is then maintained at 450°C for a sufficiently long time, preferably 30 seconds, in a forming gas environment to alloy the multi-layer contact 3.

After the alloying cycle, according to the present invention, heat is rapidly removed from the structure by way of the back surface 5 of the wafer substrate 2, with the current to the heating strip 16 turned off. Such rapid heat removal in this manner is preferably achieved by instantaneously applying a large, high heat capacity mass, such as a copper block 20, to the back surface 5. By cooling from the back surface 5, the melted surface comprising Au, Ge, Ni, Ga and As crystallizes first at the melt-GaAs interface and can grow back epitaxially, thereby reducing the amount of damage in the crystal structure under the contact and enabling a more effective $n^+$ doping of Ge in GaAs to take place. The very fast, approximately 1 second, cooling of the sample using copper block 20 may also enhance this process. After cooling, the residual $SiO_2$ layer 14 is stripped off in a conventional manner, for instance in a dilute solution of buffered hydrofluoric acid.

The ohmic contacts formed to the GaAs layer 6 by this process exhibits a very fine, high density, uniform granular structure which is GeNi rich, as opposed to a large grain low density structure obtained from the conventional process. More specifically, observation by scanning electron microscope of the structure formed by the above-described process indicates a granular structure density of about $5 \times 10^8$ cm², as compared with a density of about $3.5 \times 10^8$ cm² observed in samples using the conventional process. Also observed is the absence of elongate granular structures which are usually present in samples from the conventional process.  An increase in granular structure and an absence of elongate structure are usually associated with lower contact resistivity which is described next.

Measurements employing the "transmission line method" (TLM) of ohmic contacts 3 formed in accordance with the invention indicate a contact resistivity of about 6 x $10^{-7}$ $\Omega$ cm², which is 5 to 6 times lower than similar contacts alloyed in the conventional process.  In addition to the advantage of substantially lower resistivity, the very fine granularity and higher uniformity of the ohmic contact may also enhance it's aging characteristics.

Although the specific process described above involved a multi-layer contact metallurgy for an n-type GaAs layer, it is possible to apply the process generally to an n-type Group III-V semiconductor. Furthermore, a process, according to the present invention, may be adapted and applied to other metallurgies, or on different semiconductors, wherein an alloying cycle is employed.

**0077893**

CLAIMS

1.    A method of making an ohmic contact to an N-type Group III-V
semiconductor layer (6) supported on one surface of a substrate (2), the
method comprising the successive steps of depositing a layer (8,10,12)
of contact material on the semiconductor layer (6), heating the
structure to cause the contact material to form an alloy contact to the
semiconductor layer and rapidly cooling the structure and being
characterised by the rapid cooling being effected by removal of heat
from the opposite surface (5) of the substrate (2) to that supporting
the semiconductor layer (6) by contacting said opposite surface with a
heat sink (20).

2.    A method as claimed in claim 1, in which the semiconductor layer is
an N-type gallium arsenide layer.

3.    A method as claimed in claim 2, in which the contact material
consists of nickel, gold and germanium.

4.    A method as claimed in claim 3, in which the contact material is
covered with a layer of silicon dioxide prior to the alloying step.

5.    A method as claimed in claim 3 or claim 4, in which the alloying
step comprises heating the structure to a temperature in the range of
400°C to 500°C, for approximately 30 seconds.

FIG. 1

FIG. 2

HEAT FLOW

FIG. 3

TEMP.
(°C)

450°C

10        40

t (sec.) ——→